# EUROPEAN PATENT SPECIFICATION

(11) **EP 2 558 908 B1**
(45) Date of publication and mention of the grant of the patent: **03.06.2015**
(21) Application number: 11718182.6
(22) Date of filing: 12.04.2011
(51) Int. Cl.: G03F 7/038, G03F 7/40, G03F 7/12

(54) **PHOTORESIST FILM AND METHODS FOR ABRASIVE ETCHING AND CUTTING**
FOTOLACKFOLIE UND VERFAHREN FÜR ABRASIONSÄTZEN UND SCHNEIDEN
FILM DE RÉSINE PHOTOSENSIBLE ET PROCÉDÉS DE GRAVURE ET DE COUPE ABRASIVE

(30) Priority: 12.04.2010 US 323192 P
(43) Date of publication of application: 20.02.2013
(73) Proprietor: Ikonics Corporation, Duluth, MN 55807 (US)
(72) Inventor: MENOR, Daniel, B., Duluth, MN 55803 (US); LIBERI, Vincent, E., Avondale, PA 19311 (US)
(74) Representative: Eisenführ Speiser
(86) International application number: PCT/US2011/032154
(87) International publication number: WO 2011/130300

(56) References cited:
- EP-A1- 0 506 959
- JP-A- 62 250 440
- US-A- 5 415 971
- US-A- 5 989 689
- US-A- 6 140 006

## Description

This application is being filed as a PCT International Patent application on April 12, 2011 in the name of Ikonics Corporation, a U.S. national corporation, applicant for the designation of all countries except the U.S., and Daniel B. Menor, a U.S. citizen, and Vincent E. Liberi, a U.S. citizen, applicants for the designation of the U.S. only, and claims priority to U.S. Provisional Patent Application Serial No. 61/323,192, filed April 12, 2010, titled "PHOTORESIST FILM AND METHODS FOR ABRASIVE ETCHING AND CUTTING," the contents of which are herein incorporated by reference.

### Field of the Invention

The present invention is directed to photoresist films for use in abrasive blasting of a substrate, such as etching a substrate surface or cutting through a substrate surface. The invention is further directed to methods of abrasive blasting using a photoresist film. EP 0 506 959 A1 relates to a method for forming images by engraving through sand blasting or by etching with chemicals, for instance, solutions of etching agents through an image-carrying mask such as picture images, patterns or letters on the surface of materials to be processed such as glass, stone, pottery, metals, plastics, wooden materials and leather as well as a photo-sensitive laminate film for use in making such an image-carrying mask. US 5,415,971 A shows a photosensitive mask laminate having a photoimageable, pressure sensitive adhesive layer and a photoimageable masking layer is disclosed. The laminate also includes a support layer, and it can include a removable carrier layer and a release layer. The laminate can be imaged by selective exposure to light or other radiation, and developing the laminate produces a mask having void and mask areas. The mask can then be used to protect selected portions of a target surface during a sandblast decorative process. US 6,140,006 A discloses an integral membrane which can be formed in sheet-like photosensitive laminate structures. The process for forming the structure involves coating a first relatively thin photosensitive layer on a substrate or carrier film, then forming a second relatively thicker photosensitive layer (when compared to the first layer) on the first layer. The structure is exposed by directing appropriate actinic radiation against the substrate, film or carrier layer under controlled conditions such that only the first layer is substantially exposed to radiation resulting in polymerization or crosslinking and a substantial reduction in the solubility of the first layer. The relatively thinner less soluble layer then acts as a peelable integral release layer in the photosensitive structure. The thicker second layer can then be imagewise exposed to actinic radiation, and then used conventionally in imaging processes such as sandblasting. US 5,989,689 A shows a sandblast mask laminate useful in sandblasting operations. The laminate comprises a photoresist mask layer, a pressure sensitive adhesive composition comprising a non-elastomeric resin and a tackifier in combination to produce a composition having a Tg of less than about -40° C., a carrier film layer and a release liner. JP 62250440 A shows a photosensitive resin composition which is composed of an aqueous emulsion containing the partially saponified vinylacetate polymer which has a styrbazolium group and 70W99mol% saponification degree, and the hydrophobic polymer emulsion. The aqueous emulsion contains 1W50wt% of water insoluble inorg. solid matter based on the solid component contained in the aqueous emulsion. Thus, the partially saponified vinylacetate polymer, which forms a continuous phase, is cross-linked and cured in the presence of the styrbazolium group as the photocross-linking group, and the emulsified ethylenic unsatd. compd. polymerizes, and binds with the hydrophobic polymer emulsion particles at an interface between the partially saponified vinylacetate polymer and the ethylenical unstd. emulsion particles, thereby forming a strong hardened film.

### Background of the Invention

Abrasive etching processes using photoresist films have been used for many years to allow selective removal of a material from a substrate surface. Typically a photoresist composition layer and an adhesive composition layer are combined as separate layers to form a self-adhesive film. This self-adhesive film can be laminated to a substrate, imaged using photolithography, developed to remove portions of the film, and blasted with abrasive particles to remove a portion of the substrate.

Unfortunately, adhesive residue from the adhesive composition often remains on the substrate after development and can interfere with forming shallow-profile features on a substrate, as well as precise cutting through a substrate. This problem is particularly pronounced near the edges of areas that are to be etched or cut, because adhesive residue is hardest to remove at that interface. One existing option is to more aggressively blast those areas where adhesive has not been fully removed, but this approach results in uneven etching and cutting, as well as deeper etching than is sometimes desired.

In addition to problems associated with the adhesive residue, existing photoresist laminates often contain a membrane layer that is positioned intermediate a carrier layer and a photoresist layer. This membrane layer can also interfere with blasting, especially at interface areas along the edge of the area to be blasted.

Therefore, a need exists for an improved photoresist film that overcomes these and other problems.

### Summary of the Invention

Photoresist films and methods of using the photoresist films are described. The photoresist films allow for fine-detail abrasive blasting of substrates without the use of organic solvents for development. The photoresist films can be formed without the use of a membrane or adhesive layer, both of which are typically used to secure one side of the photoresist film to a carrier and one side of the photoresist film to a substrate. Absence of the membrane and adhesive layer can provide various advantages, including the ability to generate higher resolution and finer details, especially edge details, of abrasively blasted substrates. This higher resolution can lead to the production of very fine detail, including resolution of features that are less than 100 µm in some implementations, and even less than 75 µm.

The photoresist films are advantageous because, in addition to a lack of membrane and adhesive layer, they can be constructed so as to provide superior adhesion to a substrate even without a pressure sensitive adhesive as is commonly used with present films. Also, the photoresist films are developable and cleanable with no need for a solvent other than warm water.

The films can be developed, blasted and cleaned without the need to use an organic solvent to remove portions of the film after development or to use an organic solvent after blasting has been completed. This ability to remove portions of the photoresist film is true both in terms of not needing a solvent to remove remaining photoresist material, as well as not needing a solvent to remove any residual adhesive material either after development or after blasting (because no adhesive material is generally used).

The photoresist films produced in accordance with the invention are typically more resistant to abrasives than prior art water-processible films or any other known dry photoresist films of equal thicknesses. Thus, the photoresist films of the present invention allow for thin, strong films to be produced that are free of an adhesive layer. These films allow for very high resolution capabilities, including resolutions of details of less than 100 µm, less than 75 µm, and even less than 50 µm.

The photoresist films of the present invention typically include an ethylene-vinyl acetate copolymer ("EVA"), a polyvinyl acetate ("PVAc"), and a photo polymer. Suitable photopolymers include polyvinyl alcohol modified with photoactive crosslinkable side chains. Alternate resins and additives may be included as needed to optimize photoresist properties.

The ethylene-vinyl acetate (EVA) copolymer is typically present at a level below 90 percent dry weight of the film, more typically below 80 percent dry weight. In some implementations the ethylene-vinyl acetate copolymer is from 20 to 70 percent by dry weight of the final composition, and optionally from 30 to 60 percent by dry weight of the final composition. Frequently the ethylene-vinyl acetate copolymer is present at levels of 35 to 55 percent by dry weight of the final composition. It will be understood that while ethylene-vinyl acetate copolymer is generally used to form the photoresist film, in some implementations no ethylene-vinyl acetate copolymer is present.

Poly-vinyl acetate (PVAc) copolymer is typically utilized at levels below 90 percent dry weight of the film, more typically less than 80 percent dry weight. Typically at least 5 percent dry weight of the film is derived from poly-vinyl acetate copolymer, more typically at least 10 percent dry weight of the film is derived from poly-vinyl acetate copolymer. In certain embodiments poly-vinyl acetate copolymer comprises from 20 to 70 percent of the photoresist film by dry weight, alternatively from 25 to 65 percent of the photoresist film by dry weight.

The photopolymer, such as modified polyvinyl alcohol, is generally present at levels below 20 percent by dry weight of the photoresist film, more commonly less than 15 percent by dry weight, and often less than 10 percent by dry weight. In some implementations greater than 2 percent of the photoresist film is derived from the photopolymer, often greater than 4 percent, and optionally greater than six percent. Suitable ranges include from 3 to 15 percent, from 4 to 12 percent, and from 6 to 9 percent of polyvinyl alcohol photopolymer by dry weight of the photoresist film composition. A suitable polyvinyl alcohol photopolymer includes, for example, stilbazolium quaternary (SBQ) polyvinyl alcohol.

The photoresist film thickness can be range from, for example 0.5 mil to 15 mil. It will be understood that thinner or thicker films can be suitable for some implementations. The photoresist material is typically provided on a carrier film, such as a PET carrier film. Other suitable films include, for example, biaxially oriented polypropylene, high density polyethylene, low density polyethylene, or other polymeric films may be used as well. Carrier film thickness can vary depending upon the application, but suitable carrier films include 2 mil PET carriers.

The photoresist films of the present invention typically are used in a multi-step process to produce excellent abrasive blasting results, the steps including: application to a substrate surface, initial adherence to the substrate surface, masking with a photo tool, exposure to UV radiation, development with water to remove part of the photoresist material, drying, abrasive blasting, and removal of remaining photoresist material. These steps will be described below in greater detail.

### Detailed Description of the Invention

Photoresist films and methods of using the photoresist films are described. The photoresist films allow for fine-detail abrasive blasting of substrates without the use of organic solvents for development. The photoresist films can be formed without the use of a membrane or adhesive layer, both of which are typically used to secure one side of the photoresist film to a carrier and one side of the photoresist film to a substrate. Thus, in certain embodiments the photoresist film is a single layer that is applied to a substrate to be blasted (although the photoresist film may be provided on a removable carrier sheet for storage and application to the surface to be etched. Absence of the membrane and adhesive layer can provide various advantages, including the ability to generate higher resolution and finer details, especially edge details, of abrasively blasted substrates. This higher resolution can lead to the production of very fine detail, including resolution of features that are less than 100 µm in some implementations, and even less than 75 µm.

The photoresist films are advantageous because, in addition to a lack of membrane and adhesive layer, they can be constructed so as to provide superior adhesion to a substrate even without a pressure sensitive adhesive as is commonly used with present films. Also, the photoresist films are developable and cleanable with no need for a solvent other than warm water. Thus, the films can be developed, blasted and cleaned without the need to use an organic solvent to remove portions of the film after development or to use an organic solvent after blasting has been completed. This ability to remove portions of the photoresist film is true both in terms of not needing a solvent to remove remaining photoresist material, as well as not needing a solvent to remove any residual adhesive material either after development or after blasting (because no adhesive material is generally used).

The photoresist films produced in accordance with the invention are typically more resistant to abrasives than prior art water-processible films or any other known dry photoresist films of equal thicknesses. Thus, the photoresist films of the present invention allow for thin, strong films to be produced that are free of an adhesive layer. These films allow for very high resolution capabilities, including resolutions of details of less than 100 µm, less than 75 µm, and even less than 50 µm.

The improved resolution of the present films is evident in forming a variety of structures, including lines, holes, and posts. In the case of lines, a 75 µm thick film can be used to form a 75 µm wide line that is fully open after development, and a 50 µm line that is at least partially open at the substrate level.

The same 75 µm thick film can be used to produce a 100 µm diameter hole in the film that is completely or nearly completely open at the base of the film (where the film contacts the substrate). Smaller holes are also possible, and result in fine detail although not necessarily as uniformly. For example, a 50 µm hole can be produced that tapers from top to bottom such that it is 50 µm diameter at the top, but approximately 34 µm in diameter at the bottom.

Posts, which are areas of photoresist with surrounding photoresist material removed, can also be formed with high resolution. For example, posts with just 200 µm diameters can be created using a 75 µm thick film.

These lines, holes and posts are examples of the types of finely detailed structures that can be formed using the present films. The benefit of the films is not only the ability to create such fine details in the films, but the durability of the films to abrasive etching. Although alternative films can provide fine detail in the film itself (for example, conventional alkaline processing films) they do not provide adequate resistance to abrasives. Thus, the present invention allows for formation of a very thin film that will process effectively to create fine resolution while still surviving abrasive etching adequately to achieve desirable substrate etching.

In addition, the present films demonstrate a reduction in the size of substrate edge chipping when comparing this film to films with an adhesive layer. After blasting, the increase in hole size as compared to the photo tool is less than with self adhesive films, thereby offering a truer reproduction of the photo tool.

The photoresist films of the present invention typically include an ethylene-vinyl acetate copolymer ("EVA"), a polyvinyl acetate ("PVAc"), and a photo polymer. Suitable photopolymers include polyvinyl alcohol modified with photoactive crosslinkable side chains. Alternate resins and additives may be included as needed to optimize photoresist properties.

### Photoresist Film Composition

The photoresist films of the present invention typically include an ethylene-vinyl acetate copolymer ("EVA"), a polyvinyl acetate ("PVAc"), and a photo polymer. Suitable photopolymers include polyvinyl alcohol-based photopolymers. Alternate resins and additives may be included as needed to optimize photoresist properties.

The ethylene-vinyl acetate (EVA) copolymer is typically present at a level below 90 percent dry weight of the film, more typically below 80 percent dry weight. In some implementations the ethylene-vinyl acetate copolymer is from 20 to 70 percent by dry weight of the final composition, and optionally from 30 to 60 percent by dry weight of the final composition. Frequently the ethylene-vinyl acetate copolymer is present at levels of 35 to 55 percent by dry weight of the final composition. It will be understood that while ethylene-vinyl acetate copolymer is generally used to form the photoresist film, in some implementations no ethylene-vinyl acetate copolymer is present.

Poly-vinyl acetate (PVAc) copolymer is typically utilized at levels below 90 percent dry weight of the film, more typically less than 80 percent dry weight. Typically at least 5 percent dry weight of the film is derived from poly-vinyl acetate copolymer, more typically at least 10 percent dry weight of the film is derived from poly-vinyl acetate copolymer. In certain embodiments poly-vinyl acetate copolymer comprises from 20 to 70 percent of the photoresist film by dry weight, alternatively from 25 to 65 percent of the photoresist film by dry weight.

The photopolymer, such as modified polyvinyl alcohol, is generally present at levels below 20 percent by dry weight of the photoresist film, more commonly less than 15 percent by dry weight, and often less than 10 percent by dry weight. In some implementations greater than 2 percent of the photoresist film is derived from the photopolymer, often greater than 4 percent, and optionally greater than six percent. Suitable ranges include from 3 to 15 percent, from 4 to 12 percent, and from 6 to 9 percent of polyvinyl alcohol photopolymer by dry weight of the photoresist film composition. A suitable polyvinyl alcohol photopolymer includes, for example, stilbazolium quaternary (SBQ) polyvinyl alcohol.

The photoresist film thickness can be range from, for example 0.5 mil to 15 mil. It will be understood that thinner or thicker films can be suitable for some implementations. The photoresist material is typically provided on a carrier film, such as a PET carrier film. Other suitable films include, for example, biaxially oriented polypropylene, high density polyethylene, low density polyethylene, or other polymeric films may be used as well. Carrier film thickness can vary depending upon the application, but suitable carrier films include 2 mil PET carriers.

Thus, in many implementations the photoresist film of the present invention can be comprise a film with two functional layers: a photoresist layer containing EVA, PVAc, and a photopolymer (as well as other ingredients), plus a carrier layer made of PET or other similar material. It will be understood that protective films or layers can be applied to keep clean the surface of the photoresist material opposite the carrier layer, and to prevent blocking. It will also be understood that other layers, films, and materials can be added in some implementations without deviating from the scope and spirit of the claims.

In an example implementation the photoresist film comprises a photosensitive layer comprising a photosensitive layer comprising from 20 to 80 weight percent ethylene-vinyl acetate copolymer, less than 20 percent polyvinyl acetate, and less than 40 percent of a photopolymer. In an alternative example the film comprises a photosensitive layer comprising a photosensitive layer comprising from 20 to 40 weight percent ethylene-vinyl acetate copolymer, and 20 to 40 percent polyvinyl acetate, and less than 40 percent of a photopolymer (in an alternative, less than 30 percent photopolymer. In yet another implementation, the film comprises a photosensitive layer comprising a photosensitive layer comprising from 50 to 80 weight percent ethylene-vinyl acetate copolymer, less than 10 percent polyvinyl acetate, and less than 40 percent of a photopolymer. In yet another implementation, the film comprises a photosensitive layer comprising a photosensitive layer comprising from 40 to 80 weight percent ethylene-vinyl acetate copolymer, less than 10 percent polyvinyl acetate, and less than 40 percent of a photopolymer. In yet another implementation, the film comprises a photosensitive layer comprising a photosensitive layer comprising from 50 to 70 weight percent ethylene-vinyl acetate copolymer, and less than 20 percent polyvinyl acetate, and less than 40 percent of a photopolymer. In yet another implementation, the film comprises a photosensitive layer comprising a photosensitive layer comprising from 50 to 70 weight percent ethylene-vinyl acetate copolymer, and less than 20 percent polyvinyl acetate, and less than 30 percent of a photopolymer. In yet another implementation, the film comprises a photosensitive layer comprising a photosensitive layer comprising from 50 to 70 weight percent ethylene-vinyl acetate copolymer, and less than 10 percent polyvinyl acetate, and less than 30 percent of a photopolymer.

### Methods for Using the Photoresist Films

The photoresist films of the present invention typically are used in a multi-step process to produce excellent abrasive blasting results, the steps including: application to a substrate surface, initial adherence to the substrate surface, masking with a photo tool, exposure to UV radiation, development with water to remove part of the photoresist material, drying, abrasive blasting, and removal of remaining photoresist material. These steps will be described below in greater detail.

The first major step in use of the photoresist films is to secure them to a substrate (such as a metal surface, a circuit board substrate, a carbon fiber member, a piece of glass, a silicon wafer, etc.). The photoresist films of the present invention do not generally contain a pressure sensitive adhesive, and therefore do not generally adhere securely to the substrate until additional processing steps are undertaken, including application of heat and pressure to the film.

Adhesion to the substrate is initially obtained with heat and pressure during lamination, without the use of adhesives. Lamination can occur using, for example, a hot roll or a hot press. Lamination heat can be between 60°C and 80°C in certain example embodiments. In other example embodiments suitable lamination temperatures range from 50°C to 100°C. It will be noted that lamination temperatures of more than 40°C are often most desirable, but lower temperatures can be used in some implementations. For example, temperatures of 30°C or greater are sometimes suitable. In some implementations lamination temperatures of less than 40°C can be used. Higher temperatures can be advantageous in some implementations. Thus, temperatures below 80°C, below 90°C, or below 100°C are useful.

It is also possible to use temperatures above 100°C in some implementations, depending upon the length of time and pressure at which the photoresist film is applied to the substrate. Thus, higher temperatures can sometimes call for lower application pressures, and higher temperatures and pressures can reduce the length of time that the heat and pressure are applied.

Pressure can vary based on substrate type and thickness, but should be sufficient to advance the film and substrate through the laminator. Example pressures include less than 40 psig or less than 2.8 bar. Generally the photoresist laminate film of the present invention is constructed such that lamination alone promotes adequate adhesion for subsequent the photolithography steps (i.e. steps to produce an image with UV exposure and development with water).

Lamination gives the required level of adhesion to hold to the substrate during development. Initial lamination increases with higher laminating temperatures. Hand lamination is possible using water in some implementations, wherein the substrate and/or photoresist film is initially wetted before adhesion to the substrate. It can be possible to laminate with lower heat or no heat under very high relative ambient humidity.

After the photoresist sheet has been initially laminated to the substrate, the carrier sheet is generally removed, although it is possible to leave the carrier sheet during subsequent photolithography steps. Whether the carrier layer is removed or not at this stage, the next primary step is generally to selectively expose the photoresist sheet to ultraviolet (UV) light. Typically a photo tool that masks part of the UV light is used to selectively expose the photoresist sheet, although other methods of selectively radiating the photoresist can be used (such as directing a limited beam of UV light, using a UV light emitting diode that is moved across the surface of the photoresist film, etc).

The carrier may be untreated or release treated on the backside to prevent blocking. Generally the photoresist composition is coated directly onto the carrier, thus no membrane is present between the carrier and the photoresist material. The lack of a membrane can have numerous advantages, including the ability to create finer details using the photo tool, and more uniform development of the exposed film because a membrane does not interfere with removal of undeveloped photoresist material.

With regard to exposure, UV light exposure is generally necessary, and this exposure can be through the carrier film (such as where the carrier film is transparent to UV radiation), or the carrier film can be removed so that the photo tool (mask) is in direct contact with the photoresist film. When direct contact between the photoresist film and photo tool are desired, it can be advantageous to maintain low relative humidity so as to prevent adhesion of the photo tool to the substrate.

After appropriate steps have been undertaken to expose portions of the photoresist film to UV light, the photoresist is developed using water. The development process occurs while the photoresist film is still in contact with the substrate. The development process of washing and drying greatly increases adhesion to the substrate. This adhesion build up provides a strong bond between the photoresist film and substrate to withstand aggressive blasting conditions. Development can be achieved with standard water pressure or high pressure development. Thus, a further advantage of the photoresist films of the present invention are that they can be developed with plain water at a neutral pH.

After water development and drying, adhesion of the photoresist film to a substrate often increases several fold. In some implementations the adhesion of the photoresist film to a substrate increases by greater than 50 percent, in some implementations the adhesion increases by greater than 100 percent, in other implementations the adhesion increases by greater than 200 percent, and in yet other implementations the adhesion increases by greater than 300 percent. Higher adhesion strengths can be observed, including increases of 500 percent compared to the undeveloped and dried film. In some implementations the photoresist film bonds itself so tightly to a substrate that it cannot be removed by peeling after development and drying-thus the film is extremely well bonded to the substrate - and is only readily removable by exposure to warm water. This aggressive bond between the photoresist film and substrate is highly desirable because it provides great resistance to abrasives during blasting, yet is readily and completely removable by water after blasting has been completed.

Following the development steps of washing and drying, the substrate and remaining photoresist are blasted with abrasive materials, such as glass beads, sand, or other particulates, resulting in selective removal of portions of the substrate not protected by the photoresist material. The present invention allows extremely fine detail to be formed in the substrate, in part due to the lack of adhesive residue on the substrate after water development. This lack of adhesive residue allows shallow but uniform etching to be done that has relatively crisp, sharp edges. The lack of adhesive residue also allows for holes to be formed or cut into a substrate that closely match the photo tool. Thus, the present invention, including the materials and methods, allow for very precise removal of substrate material at various depths.

After abrasive blasting the remaining photoresist film can be removed from the substrate by soaking in water. Depending on water temperature, the soak time can be as short as 5 minutes or less; although longer soaking times are often necessary depending upon thickness of the film, water temperature, and whether or not any scrubbing action is applied. For example, once blasted the photoresist film will generally easily come off a substrate after soaking in warm (e.g. 60°C) plain water.

Compared to films with an adhesive layer, a significant reduction of the residue left on substrate after development is achieved. Also one benefit of the present invention is that straighter side walls on processed films are seen when compared to films with an adhesive layer. Thus, the present invention provides a superior film construction that obtains excellent performance properties despite being free of an adhesive layer and being water developed.

As noted above, in an example implementation the photoresist film of the present invention does not contain a membrane layer. Therefore, the photoresist film can be exposed to UV light and processed directly on a substrate. This ability to provide a water based photoresist film without a membrane is highly advantageous in that optimum registration of features is obtained. In contrast, photoresist films containing a membrane are generally developed prior to application to the substrate, and therefore it is difficult, and sometimes impossible to provide precise registration. Precise registration is often essential for many applications, such as the etching of features into an electronic circuit board. As such boards become smaller and more complicated, the ability to precisely register a photoresist mask is increasingly important.

As noted above, the photoresist film of the present invention has very little initial adhesion to typical substrates (such as metal surfaces) until heat and pressure have been applied. It will be noted that pressure alone will not generally create a strong bond between the photoresist film and substrate, but rather increased temperatures are generally needed. Once the photoresist film has been placed on a substrate and subjected to an increased temperature while under pressure, the film forms a secure bond to the substrate sufficient to allow handling, exposure to UV light and development with water. After this film is developed and dries it becomes extremely well bonded to substrates, generally at least twice as well bonded as before development and drying, and often multiples of times better bonded as before development and drying. The increased adhesion of the photoresist film to a substrate can be very important, allowing fine details to be created during abrasive blasting. It is possible, using the film and methods of the invention, to form fine details of less than 1000 µm, of less than 500 µm, less than 200 µm, less than 100 µm and even less than 50 µm in some implementations.

The photoresist films produced in accordance with the invention are typically more resistant to abrasives than prior art water processible or any other known dry film photoresist films of equal thicknesses. Thus, the photoresist films of the present invention allow for thin, strong films to be produced that are free of an adhesive layer. These films allow for very high resolution capabilities, including resolutions of less than 100 µm, less than 75 µm, and even less than 50 µm.

The improved resolution of the present films is evident in forming a variety of structures: lines, holes, and posts. In the case of lines, a 75 µm thick film can be used to form a 75 µm wide line that is fully open, and a 50 µm line that is at least partially open. A film in which a specific diameter hole can be formed is considered to have an "open hole" resolution of the diameter of that hole. For example, a film in which a 75 µm hole is formed at the base of the opening (the area of the film in contact with the substrate to be etched) will be considered to have a 75 µm open hole resolution. Similarly, a film in which a 100 µm hole is formed at the base of the opening will be considered to have a 100 µm open hole resolution.

It is important, however, to distinguish between the minimum amount of exposed substrate that is not covered by the film (open hole resolution), and the effective open hole resolution as it pertains to abrasive etching, which is the resolution of details that can be etched into the substrate: Not only must fine details be formed in the photoresist film, but that detail must be achievable in the subsequent abrasive etching. If a developed resist has an open hole diameter of 100 µm, but the surrounding film is thin or otherwise weakened to the point that it does not adequately resist abrasion during abrasive etching, then the effective open hole resolution is actually higher. For example, a film that is formed so as to have an open hole diameter of 100 µm will be one in which UV exposure and development of the photoresist film will result in exposed substrate areas as small as 100 µm. If under normal abrasive etching the edge of the film around the open whole readily degrades or ablates, such that the etched portion of the substrate is 150 µm, then the effective open hole diameter not 100 µm, but rather 150 µm. One of the advantages of the present invention is that it allows for a substantial correlation between the open hole resolution in the film and the effective open hole resolution during abrasive etching even with very thin films. This is true because the thin film is very durable, and develops in a manner that allows for sharp, well defined edges of the photoresist film.

These lines, holes and posts are examples of the types of fine detail structures that can be formed using the present films. The benefit of the films is not only the ability to create such fine details in the films, but the durability of the films to abrasive etching. Although alternative films can provide fine detail in the film itself, for example, conventional alkaline processing films, they do not provide adequate resistance to abrasives. Thus, the present invention allows for formation of a very thin film that will process effectively to create fine resolution while still surviving abrasive etching adequately to achieve desirable substrate etching.

It will be understood that resolution can be enhanced by removing the carrier prior to light exposure, providing intimate contact between the photo tool and the photoresist film. The low tackiness of the photoresist film allows the photo tool to be placed directly on top of the photoresist layer, and avoids adhesion of the photo tool to the photoresist. This avoids damage to the photoresist upon removal of the photo tool, a problem which can otherwise occur.

### Example formulations

The following examples and comparative examples are provided. Compositions are provided by percent of total by wet weight of coating fluid; examples 1 and 7 below include the corresponding dry weight of each component in coated films.

Sources for the ingredients used for the examples were as follows: Vinnapas 400 (EVA): Air Products Polymers, Allentown PA; Vinnapas 320 (EVA): Air Products Polymers, Allentown PA; PN 3178Z (PVAc): H.B. Fuller, St. Paul MN; Benzoflex 50 (plasticizer): Eastman, Kingsport TN; 540 SBQ (: IKONICS Corporation, Duluth MN; Zonyl FSO: DuPont, Wilmington DE; Unisperse Blue GE (pigment): BASF Corporation, Florham Park NJ; Flexbond 150 (adhesive): Air Products, Allentown PA; Rubine F6B (pigment): Clariant GmbH, Frankfurt Germany; XR-2223 (PVAc): H.B. Fuller, St. Paul MN.

### Example 1

This example shows a preferred formulation in which the most common ingredient is ethylene-vinyl acetate copolymer (EVA), along with polyvinyl acetated (PVAc) at a level of approximately one tenth of the EVA (measured as weight percent). A PVA photopolymer is provided in significant quantities, in this case approximately one half of the level of the EVA (in weight percent). A surfactant is include, along with blue pigment and isopropanol. No further plasticizer is necessary, because films made using the formulation have adequate flexibility without addition of a plasticizer. This formulation has a good balance of adhesion, resolution, flexibility, and blast resistance.

| | Wt. % (wet) | dry solids |
|---|---|---|
| Vinnapas 400 (EVA) | 61.40 | 33.77 |
| PN 3178Z (PVAc) | 06.81 | 03.75 |
| Benzoflex 50 (plasticizer) | 00.00 | 00.00 |
| 540 SBQ (PVA photopolymer) | 30.00 | 03.75 |
| Zonyl FSO (surfactant) | 00.11 | 00.11 |
| Unisperse Blue GE (pigment) | 00.10 | 00.05 |
| Isopropanol | 01.58 | 00.00 |

### Example 2

This example shows a preferred formulation in which the most common material is ethylene-vinyl acetate copolymer (EVA), along with polyvinyl acetated (PVAc) at a level of approximately one tenth of the EVA (measured as weight percent). A PVA photopolmer is included in significant quantities, in this case approximately one half of the level of the EVA (in weight percent). A surfactant is provided, along with red pigment and isopropanol. This example is identical to example 1, but has a different pigment and more pigment than example 1. No further plasticizer is necessary because films made using the composition have adequate flexibility without addition of a plasticizer. This formulation has a good balance of adhesion, resolution, flexibility, and blast resistance.

| | Wt. % (wet) |
|---|---|
| Vinnapas 400 (EVA) | 61.30 |
| PN 3178 Z (PVAc) | 6.81 |
| Flexbond150 (adhesive) | 0 |
| Benzoflex 50 (plast.) | 0 |
| 540 SBQ (PVA photo) | 30.00 |
| Zonyl FSO (surfactant) | 0.11 |
| Rubine F6B (pigment) | 0.20 |
| Isopropanol | 1.58 |

### Example 3

This example has substantially equal levels of EVA and PVAc, along with similar levels of PVA photopolymer. No additional adhesive or plasticizer is added. This composition produces films that have lower blast resistance and adhesion relative to Examples 1 and 2, but which have improved flexibility over comparative examples provided below.

| | Wt.%(wet) |
|---|---|
| Vinnapas 400 (EVA) | 34.11 |
| PN 3178 Z (PVAc) | 34.00 |
| Flexbond-150 (adhesive) | 0 |
| Benzoflex 50 (plast.) | 0 |
| 540 SBQ (PVA photo) | 30.00 |
| Zonyl FSO (surfactant) | 0.11 |
| Rubine F6B (pigment) | 0.20 |
| Isopropanol | 1.58 |

### Example 4

This example is similar to Example 3, but lacks preferred levels of adhesion, blast resistance, and flexibility relative to examples 1 and 2.

| | Wt. % (wet) |
|---|---|
| Vinnapas 400 (EVA) | 30.00 |
| PN 3178 Z (PVAc) | 40.91 |
| Flexbond-150 (adhesive) | 0 |
| Benzoflex 50 (plast.) | 7.80 |
| 540 SBQ (PVA photo) | 19.40 |
| Zonyl FSO (surfactant) | 0.11 |
| Rubine F6B (pigment) | 0.20 |
| Isopropanol | 1.58 |

### Example 5

This example shows good flexibility but lower than desired blast resistance and adhesion compared to Examples 1 and 2. The primary difference is use of a different PVAc than in example 1 and 2.

| | Wt. % (wet) |
|---|---|
| XR-2223 (PVAc) | 61.30 |
| PN 3178Z (PVAc) | 6.81 |
| 540 SBQ (PVA photo) | 30.00 |
| Zonyl FSO (surfactant) | 0.11 |
| Rubine F6B (pigment) | 0.20 |
| Isopropanol | 1.58 |

### Example 6

This formulation has less adhesion, flexibility, and blast resistance than formulas in Example 1 and 2, and is lower than preferred performance levels in these parameters.

| | Wt. % (wet) |
|---|---|
| Vinnapas 320 (EVA) | 61.30 |
| PN 3178Z (PVAc) | 6.81 |
| 540 SBQ (PVA photo) | 30.00 |
| Zonyl FSO (surfactant) | 0.11 |
| Rubine F6B (pigment) | 0.20 |
| Isopropanol | 1.58 |

### Example 7

This formulation produces films that have inferior blast resistance and adhesion relative to Examples 1 and 2, but which has improved flexibility over comparative examples provided below.

| | Wt. % (wet) | dry solids |
|---|---|---|
| Vinnapas 400 (EVA) | 30.10 | 16.56 |
| PN 3178Z (PVAc) | 40.91 | 22.50 |
| Benzoflex 50 (plasticizer) | 07.80 | 07.80 |
| 540 SBQ (PVA photopolymer) | 19.40 | 02.43 |
| Zonyl FSO (surfactant) | 00.11 | 00.11 |
| Unisperse Blue GE (pigment) | 00.10 | 00.05 |
| Isopropanol | 01.58 | 00.00 |

### Comparative Example 1

This comparative example shows a formulation without EVA, but high levels of PVAc. It also has relatively low levels of the PVA photopolymer. The result is a material that forms films that are brittle, have low blast resistance, and that have a tendency to crack at cooler temperatures. In addition, without EVA or an adhesive, films made from this formulation have very little adhesion to a substrate even with hot lamination. This formulation has low adhesion, blast resistance, and flexibility.

| | Wt. % (wet) |
|---|---|
| Vinnapas 400 (EVA) | 0 |
| PN 3178 Z (PVAc) | 70.91 |
| Flexbond-150 (adhesive) | 0 |
| Benzoflex 50 (plast.) | 7.80 |
| 540 SBQ (PVA photo) | 19.40 |
| Zonyl FSO (surfactant) | 0.11 |
| Rubine F6B (pigment) | 0.20 |
| Isopropanol | 1.58 |

### Comparative Example 2

This comparative example shows a formulation without EVA, but high levels of PVAc. It also has relatively low levels of the PVA photopolymer. Adhesion is improved over comparative Example 1, due to the presence of an adhesive. However, the material forms films which are brittle, have low blast resistance, and which have a tendency to crack at cooler temperatures. This formulation has low adhesion, blast resistance, and flexibility.

| | Wt. % (wet) |
|---|---|
| Vinnapas 400 (EVA) | 0 |
| PN 3178 Z (PVAc) | 65.91 |
| Flexbond-150 (adhesive) | 5.00 |
| Benzoflex 50 (plast.) | 7.80 |
| 540 SBQ (PVA photo) | 19.40 |
| Zonyl FSO (surfactant) | 0.11 |
| Rubine F6B (pigment) | 0.20 |
| Isopropanol | 1.58 |

### Comparative Example 3

This formulation is similar to comparative example 2, but contains significantly more adhesive. The result is improved adhesion, but the material forms films that are relatively brittle, have inferior blast resistance, and which have a tendency to crack at cooler temperatures.

| | Wt. % (wet) |
|---|---|
| Vinnapas 400 (EVA) | 0 |
| PN 3178 Z (PVAc) | 60.91 |
| Flexbond-150 (adhesive) | 10.00 |
| Benzoflex 50 (plast.) | 7.80 |
| 540 SBQ (PVA photo) | 19.40 |
| Zonyl FSO (surfactant) | 0.11 |
| Rubine F6B (pigment) | 0.20 |
| Isopropanol | 1.58 |

### Comparative Example 4

This comparative example shows improved flexibility over compositions that do not contain EVA. However, adhesion and blast resistance are still below preferred levels, and flexibility is also less than desired.

| | Wt. % (wet) |
|---|---|
| Vinnapas 400 (EVA) | 20.00 |
| PN 3178 Z (PVAc) | 50.91 |
| Flexbond-150 (adhesive) | 0 |
| Benzoflex 50 (plast.) | 7.80 |
| 540 SBQ (PVA photo) | 19.40 |
| Zonyl FSO (surfactant) | 0.11 |
| Rubine F6B (pigment) | 0.20 |
| Isopropanol | 1.58 |

### Comparative Example 5

This comparative example shows a formulation without EVA, but high levels of PVAc. It also has relatively low levels of the PVA photopolymer. Adhesion is improved over comparative Example 1, due to the presence of an adhesive. However, the material forms films which are brittle, have low blast resistance, and which have a tendency to crack at cooler temperatures. This formulation has low adhesion, blast resistance, and flexibility.

| | Wt. % (wet) |
|---|---|
| PN 3178Z (PVAc) | 71.71 |
| Benzoflex 50 (plast.) | 07.00 |
| 540 SBQ (PVA photo) | 19.40 |
| Zonyl FSO (surfactant) | 0.11 |
| Rubine F6B (pigment) | 0.20 |
| Isopropanol | 1.58 |

Other embodiments of the invention will be apparent to those skilled in the art from consideration of the specification and practice of the invention disclosed herein, It is intended that the specification and examples be considered as exemplary only, with a full scope and spirit of the invention being indicated by the following claims.

## Claims

1. A photoresist sheet comprising:
a) a photosensitive layer comprising
i) from 20 to 80 weight percent ethylene-vinyl acetate copolymer,
ii) less than 20 percent polyvinyl acetate, and
iii) less than 40 percent of a photopolymer; and
b) a carrier sheet.

2. The photoresist sheet of claim 1 comprising:
a photosensitive layer comprising ethylene-vinyl acetate copolymer, polyvinyl acetate, and a photopolymer; and
a carrier sheet.

3. The photoresist sheet of any claims 1, 2, and 4 to 14, wherein the ethylene-vinyl acetate copolymer comprises from 40 to 70 percent of the photosensitive layer by dry weight of the film.

4. The photoresist sheet of any of claims 1 to 3 and 5 to 14, wherein the polyvinyl acetate comprises less than 50 percent of the photosensitive layer by dry weight of the film.

5. The photoresist sheet of any of claims 1 to 4 and 6 to 14, wherein the photopolymer comprises less than 30 percent by dry weight of the photosensitive layer by dry weight of the film.

6. The photoresist sheet of any of claims 1 to 5 and 7 to 14, wherein the sheet has a surface configured and arranged for being secured to a substrate to be abrasively blasted, and said surface is substantially free of adhesive material.

7. The photoresist sheet of any of claims 1 to 6 and 8 to 14, wherein the sheet has a surface configured and arranged for being secured to a substrate to be abrasively blasted, and said surface is substantially free of pressure-sensitive adhesive material.

8. The photoresist sheet of any of claims 1 to 7 and 9 to 14, wherein the photoresist sheet is water developable.

9. The photoresist sheet of any of claims 1 to 8 and 10 to 14, wherein the photoresist sheet is less than 100 µm thick.

10. The photoresist sheet of any of claims 1 to 9 and 11 to 14, wherein the photoresist sheet does not contain a membrane layer.

11. The photoresist sheet of claim any of claims 1 to 10 and 12 to 14, wherein the photoresist sheet has an open hole resolution of less than 75 µm.

12. The photoresist sheet of any of claims 1 to 11 and 13 to 14, wherein the photoresist sheet has an effective open hole resolution of 100 µm.

13. The photoresist sheet of any of claims 1 to 12 and 14, wherein the photoresist sheet has a thickness of less than 100 µm an effective open hole resolution of less than 100 µm.

14. The photoresist sheet of claims 1 to 13, wherein the photoresist sheet has a thickness of less than 75 µm an effective open hole resolution of less than 75 µm.

15. A method of removal of a portion of a substrate, the method comprising:
a) providing a substrate;
b) providing a photosensitive film, the photosensitive film comprising ethylene-vinyl acetate copolymer, polyvinyl acetate, and a photopolymer;
c) applying the photosensitive film to the substrate such that the photosensitive film is not meaningfully adhered to the substrate;
d) applying pressure to the photosensitive film and substrate at a temperature of at least 30°C such that the photosensitive film is meaningfully adhered to the substrate;
e) exposing at least a portion of the photosensitive film to ultraviolet light;
f) removing a portion of the photosensitive film using water or an aqueous solution so as to expose substrate surfaces free of photosensitive material and adhesive material;
g) allowing the photosensitive film to dry such that the photosensitive film is adhered to the substrate with a peel strength that is at least five times the peel strength before heat and pressure were applied, and at least two times the peel strength after heat and pressure were applied but before removal of a portion of the photosensitive film using water or an aqueous solution; and
g) abrasive blasting of the exposed substrate surfaces.

## Patentansprüche

1. Photoresist-Folie, umfassend:
a) eine lichtempfindliche Schicht, umfassend
I) von 20 bis 80 Gewichtsprozent Ethylenvinylacetat-Copolymer,
II) weniger als 20 Prozent Polyvinylacetat, und
III) weniger als 40 Prozent eines Photopolymers; und
b) eine Trägerfolie.

2. Photoresist-Folie aus Anspruch 1, umfassend:
eine lichtempfindliche Schicht, umfassend Ethylenvinylacetat-Copolymer, Polyvinylacetat und ein Photopolymer; und
eine Trägerfolie.

3. Photoresist-Folie nach einem der Ansprüche 1, 2 und 4 bis 14, wobei das Ethylenvinylacetat-Copolymer von 40 bis 70 Prozent der lichtempfindlichen Schicht nach Trockengewicht des Films umfasst.

4. Photoresist-Folie nach einem der Ansprüche 1 bis 3 und 5 bis 14, wobei das Polyvinylacetat weniger als 50 Prozent der lichtempfindlichen Schicht nach Trockengewicht des Films umfasst.

5. Photoresist-Folie nach einem der Ansprüche 1 bis 4 und 6 bis 14, wobei das Photopolymer weniger als 30 Prozent nach Trockengewicht der licht-empfindlichen Schicht nach Trockengewicht des Films umfasst.

6. Photoresist-Folie nach einem der Ansprüche 1 bis 5 und 7 bis 14, wobei die Folie eine Oberfläche aufweist, die ausgebildet und angeordnet ist, um an einem Substrat befestigt zu werden, um abtragend gestrahlt zu werden, und wobei die Oberfläche im Wesentlichen frei von Haftmaterial ist.

7. Photoresist-Folie nach einem der Ansprüche 1 bis 6 und 8 bis 14, wobei die Folie eine Oberfläche aufweist, die ausgebildet und angeordnet ist, um an einem Substrat befestigt zu werden, um abtragend gestrahlt zu werden, und wobei die Oberfläche im Wesentlichen frei von druckempfindlichen Haftmaterial ist.

8. Photoresist-Folie nach einem der Ansprüche 1 bis 7 und 9 bis 14, wobei die Photoresist-Folie in Wasser entwickelbar ist.

9. Photoresist-Folie nach einem der Ansprüche 1 bis 8 und 10 bis 14, wobei die Photoresist-Folie weniger als 100 µm dick ist.

10. Photoresist-Folie nach einem der Ansprüche 1 bis 9 und 11 bis 14, wobei die Photoresist-Folie keine Membranschicht enthält.

11. Photoresist-Folie nach einem der Ansprüche 1 bis 10 und 12 bis 14, wobei die Photoresist-Folie eine freie Bohrungs-Auflösung von weniger als 75 µm aufweist.

12. Photoresist-Folie nach einem der Ansprüche 1 bis 11 und 13 bis 14, wobei die Photoresist-Folie eine effektive freie Bohrungs-Auflösung von 100 µm aufweist.

13. Photoresist-Folie nach einem der Ansprüche 1 bis 12 und 14, wobei die Photoresist-Folie eine Dicke von weniger als 100 µm, eine effektive freie Bohrungs-Auflösung von weniger als 100 µm aufweist.

14. Photoresist-Folie nach einem der Ansprüche 1 bis 13, wobei die Photoresist-Fofie eine Dicke von weniger als 75 µm, eine effektive freie Bohrungs-Auflösung von weniger als 75 µm aufweist.

15. Verfahren zum Entfernen eines Teils eines Substrats, wobei das Verfahren umfasst:
a) Bereitstellen eines Substrats;
b) Bereitstellen eines lichtempfindlichen Films, wobei der lichtempfindliche Film Ethylenvinylazetat-Copolymer, Polyvinylacetat und ein Photopolymer umfasst;
c) den lichtempfindlichen Film auf das Substrat Anwenden, sodass der lichtempfindliche Film nicht bedeutend an dem Substrat anhaftet;
d) Druck auf den lichtempfindlichen Film und das Substrat bei einer Temperatur von wenigstens 30°C Anwenden, sodass der lichtempfindliche Film bedeutend an dem Substrat anhaftet;
e) wenigstens einen Teil des lichtempfindlichen Films ultraviolettem Licht Aussetzen;
f) Entfernen eines Teils des lichtempfindlichen Films durch Verwendung von Wasser oder einer wässrigen Lösung, um die Substratoberflächen, die frei von lichtempfindlichem Material und anhaftendem Material sind freizulegen;
g) dem lichtempfindlichen Film Ermöglichen zu trocknen, sodass der lichtempfindliche Film an dem Substrat anhaftet mit einer Haftfestigkeit, die wenigstens fünfmal die Haftfestigkeit, bevor Druck und Temperatur angewendet worden sind, beträgt, und die wenigstens zweimal die Haftfestigkeit, nachdem Druck und Temperatur angewendet worden sind, aber vor dem Entfernen eines Teils des lichtempfindlichen Films durch Verwendung von Wasser oder einer wässrigen Lösung, beträgt; und
g) abtragendes Strahlen der freigelegten Substratoberflächen.

## Revendications

1. Feuille de résine photosensible, comprenant :
a) une couche photosensible comprenant
i) de 20 à 80 pour cent en poids d'un copolymère d'éthylène/acétate de vinyle,
ii) moins de 20 pour cent d'un poly(acétate de vinyle), et
iii) moins de 40 pour cent d'un photopolymère ; et
b) une feuille de support.

2. Feuille de résine photosensible selon la revendication 1, comprenant :
une couche photosensible comprenant un copolymère d'éthylène/acétate de vinyle, un poly(acétate de vinyle) et un photopolymère ; et
une feuille de support.

3. Feuille de résine photosensible selon l'une quelconque des revendications 1, 2 et 4 à 14, dans laquelle le copolymère d'éthylène/acétate de vinyle comprend de 40 à 70 pour cent de la couche photosensible en poids sec du film.

4. Feuille de résine photosensible selon l'une quelconque des revendications 1 à 3 et 5 à 14, dans laquelle le poly(acétate de vinyle) comprend moins de 50 pour cent de la couche photosensible en poids sec du film.

5. Feuille de résine photosensible selon l'une quelconque des revendications 1 à 4 et 6 à 14, dans laquelle le photopolymère comprend moins de 30 pour cent en poids sec de la couche photosensible en poids sec du film.

6. Feuille de résine photosensible selon l'une quelconque des revendications 1 à 5 et 7 à 14, dans laquelle la feuille possède une surface configurée et conçue pour être fixée à un substrat devant être soumis à une abrasion par projection, et ladite surface est essentiellement exempte de matière adhésive.

7. Feuille de résine photosensible selon l'une quelconque des revendications 1 à 6 et 8 à 14, dans laquelle la feuille possède une surface configurée et conçue pour être fixée à un substrat devant être soumise à une abrasion par projection, et ladite surface est essentiellement exempte de matière adhésive sensible à la pression.

8. Feuille de résine photosensible selon l'une quelconque des revendications 1 à 7 et 9 à 14, dans laquelle la feuille de résine photosensible est développable dans l'eau.

9. Feuille de résine photosensible selon l'une quelconque des revendications 1 à 8 et 10 à 14, dans laquelle l'épaisseur de la feuille de résine photosensible est inférieure à 100 µm.

10. Feuille de résine photosensible selon l'une quelconque des revendications 1 à 9 et 11 à 14, dans laquelle la feuille de résine photosensible ne contient pas une couche de membrane.

11. Feuille de résine photosensible selon l'une quelconque des revendications 1 à 10 et 12 à 14, dans laquelle la feuille de résine photosensible présente une résolution de trou ouvert inférieure à 75 µm,

12. Feuille de résine photosensible selon l'une quelconque des revendications 1 à 11 et 13 à 14, dans laquelle la feuille de résine photosensible présente une résolution effective de trou ouvert de 100 µm.

13. Feuille de résine photosensible selon l'une quelconque des revendications 1 à 12 et 14, dans laquelle la feuille de résine photosensible possède une épaisseur inférieure à 100 µm, une résolution effective de trou ouvert de moins de 100 µm.

14. Feuille de résine photosensible selon l'une quelconque des revendications 1 à 13, dans laquelle la feuille de résine photosensible possède une épaisseur inférieure à 75 µm, une résolution effective de trou ouvert inférieure à 75 µm.

15. Procédé d'élimination d'une partie d'un substrat, le procédé comprenant :
a) l'obtention d'un substrat ;
b) l'obtention d'un film photosensible, le film photosensible comprenant un copolymère d'éthylène/acétate de vinyle, un poly(acétate de vinyle) et un photopolymère ;
c) l'application du film photosensible sur le substrat de telle manière que le film photosensible n'adhère pas de manière significative au substrat ;
d) l'application d'une pression au film photosensible et au substrat à une température d'au moins 30 °C, de telle manière que le film photosensible n'adhère pas de manière significative au substrat ;
e) l'exposition d'au moins une partie du film photosensible à une lumière ultraviolette ;
f) l'élimination d'une partie du film photosensible en utilisant de l'eau ou une solution aqueuse afin d'exposer les surfaces du substrat exemptes de matière photosensible et de matière adhésive ;
g) le fait de laisser sécher le film photosensible de façon que le film photosensible adhère au substrat avec une résistance au pelage qui est au moins cinq fois plus élevée que la résistance au pelage avant l'application de la chaleur et de la pression, et au moins deux fois plus élevées que la résistance au pelage après l'application de la chaleur et de la pression mais avant élimination d'une partie du film photosensible en utilisant de l'eau ou une solution aqueuse ; et
g) l'abrasion par projection des surfaces exposées du substrat.
